(19) Europäisches Patentamt
European Patent Office
Office européen des brevets

(11) Veröffentlichungsnummer: **0 078 084**
**B1**

(12) # EUROPÄISCHE PATENTSCHRIFT

(45) Veröffentlichungstag der Patentschrift: **21.09.88**

(51) Int. Cl.⁴: **H 03 L 7/10**

(21) Anmeldenummer: **82201320.7**

(22) Anmeldetag: **22.10.82**

(54) **Schaltungsanordnung mit einem umschaltbaren Glättungsglied.**

(30) Priorität: **28.10.81 DE 3142612**

(43) Veröffentlichungstag der Anmeldung: **04.05.83 Patentblatt 83/18**

(45) Bekanntmachung des Hinweises auf die Patenterteilung: **21.09.88 Patentblatt 88/38**

(84) Benannte Vertragsstaaten: **DE FR GB IT**

(56) Entgegenhaltungen:
**DE-A-2 159 223**
**US-A-3 909 735**

**PROCEEDINGS OF THE IEE, Band 123, Nr. 8, August 1976, Seiten 761-764, Stevenage, GB; J.P. McGEEHAN: "Technique for improving the pull-in characteristics of phase-locked loops"**

(73) Patentinhaber: **Philips Patentverwaltung GmbH, Wendenstrasse 35 Postfach 10 51 49, D-2000 Hamburg 1 (DE)**
(84) Benannte Vertragsstaaten: **DE**

(73) Patentinhaber: **N.V. Philips' Gloeilampenfabrieken, Groenewoudseweg 1, NL- 5621 BA Eindhoven (NL)**
(84) Benannte Vertragsstaaten: **FR GB IT**

(72) Erfinder: **Kunze, Dieter, Flottmoorring 8, D-2358 Kaltenkirchen (DE)**
Erfinder: **Onken, Gerd, Glojenbarg 32, D-2000 Norderstedt (DE)**
Erfinder: **Wölber, Jörg, Taubenstrasse 32, D-2080 Pinneberg (DE)**

(74) Vertreter: **Hartmann, Heinrich, Dipl.- Ing., Philips Patentverwaltung GmbH Wendenstrasse 35 Postfach 10 51 49, D-2000 Hamburg 1 (DE)**

**EP 0 078 084 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1988

**Beschreibung**

Die Erfindung bezieht sich auf eine Schaltungsanordung zum Übertragen einer Gleichspannung mit einem zwischen einer Eingangsklemme und einer Ausgangsklemme gegen ein Bezugspotential liegenden umschaltbaren Glättungsglied, das aus wenigstens einem Längswiderstand und dahinter im Querzweig einem, ggf. mit einem ersten Widerstand in Reihe liegenden, ersten Kondensator und einem, ggf. mit einem zweiten Widerstand in Reihe liegenden, zweiten Kondensator besteht, der zur Vergrößerung der Zeitkonstante an die Ausgangsklemme angeschaltet werden kann.

Bei bekannten Schaltungen dieser Alt, die z. B. zur Regelung eines spannungsgesteuerten Oszillators verwendet werden können, wird normalerweise eine sich ändernde Spannung übertragen. Wenn der zweite Kondensator abgeschaltet ist, steht an ihm in der Regel eine andere Spannung als am ersten Kondensator. Sobald der zweite Kondensator eingeschaltet wird, fließt zu ihm ein Lade- oder Entladestrom, und dementsprechend gibt es einen Spannungsstoß, der sich auf die übertragene Spannung auswirkt, und der nachteilige Folgen haben kann. z. B. kann der Oszillator aus dem Fangbereich geraten, was eine neue Umschaltung verursacht. Der Oszillator fängt aufs neue ein, usw. Hierbei vergeht eine lange Zeit, bis der Regelkreis endgültig auf die langsame Zeitkonstante umgeschaltet hat.

Der Erfindung liegt die Aufgabe zugrunde, diesen Spannungsstoß zu vermeiden.

Diese Aufgabe wird nach der Erfindung dadurch gelöst, daß mit der Ausgangsklemme der Eingang eines Verstärkers mit hoher Eingangsimpedanz und mit einem Verstärkungsfaktor von wenigstens annähernd 1 verbunden ist, dessen Ausgang mit dem zweiten Kondensator derart verbindbar ist, daß dieser im Glättungsglied wahlweise wirksam oder nicht wirksam ist, und daß bei nicht wirksamem Kondensator die Spannung von der Ausgangsklemme über den Verstärker auf den zweiten Kondensator übertragen wird.

Nach einer bevorzugten Ausführungsform liegt der Ausgang des Verstärkers an einer Ausgangsklemme eines Umschalters, dessen umschaltbare Zunge mit dem zweiten Kondensator verbunden ist, und dessen andere Ausgangsklemme an die Ausgangsklemme des Glättungsfilters angeschlossen ist.

Nach einer anderen bevorzugten Ausführungsform ist der zweite Kondensator über den zweiten Widerstand mit der Ausgangsklemme verbunden, parallel zum zweiten Widerstand ist der Verstärker angeschlossen, und der Verstärker wird zwischen dem Verstärkungsfaktor Null und wenigstens annähernd 1 umgeschaltet. In diesem Fall ist ein Umschalter im Zweig des Glättungskondensators nicht erforderlich; die Umschaltung wird durch eine Steuergroße bewirkt, die den Verstärker zwischen dem Verstärkungsfaktor 1 und Null umschaltet. Im ersten Fall wird die Spannung des zweiten Kondensators mit der Spannung des ersten Kondensators mitgesteuert, so daß über den zweiten Widerstand kein Strom fließt und der zweite Widerstand für das Glättungsfilter unwirksam ist. Im zweiten Falle ist der zweite Kondensator über den Widerstand an das Glättungsfilter angeschlossen. Dieser Widerstand braucht nicht groß zu sein, derart, daß der zweite Kondensator praktisch direkt an die Ausgangsklemme angeschlossen ist.

Der Vollständigkeit halber sei bemerkt, daß es aus der DE-OS-2 159 223 bekannt ist, einem im Längszweig des Glättungsfilters liegenden Widerstand einen als Schalter wirksamen Transistorverstärker parallel zu schalten und diesem Verstärker ein Schaltsignal zuzuführen. Wenn dieser Verstärker unwirksam ist, ist der Längswiderstand voll in das Glättungsfilter eingeschaltet. Wenn dagegen der Schaltverstärker Strom führt, wird dem Längswiderstand ein weiterer Widerstandszweig parallel geschaltet derart, daß der effektive Widerstandswert wesentlich vermindert und dadurch die Grenzfrequenz des Glättungsfilters entsprechend erhöht ist. Da dieser Längswiderstand auch Strom führen kann, ist ein Spannungsstoß in der übertragenen Gleichspannung nicht vermieden. Außerdem wird die Längsimpedanz des Glättungsfilters verändert, was unerwünscht sein kann.

Die Erfindung wird nachstehend anhand der Zeichnung beispielsweise näher erläutert, die in

Fig. 1 ein Prinzipschaltbild und in

Fig. 2 eine Detailschaltung mit Steuerung durch eine angelegte Spannung V zeigt.

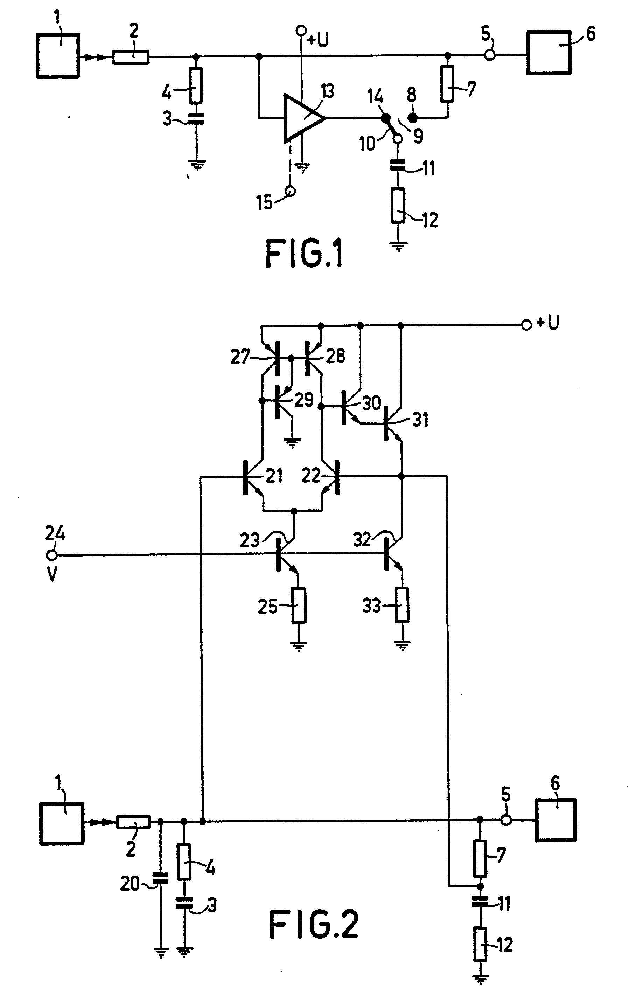

In Fig. 1 wird von einer Regelspannungsquelle 1 eine Gleichspannung in der Größenordnung von einigen Volt, z. B. 6 Volt ± 2 Volt, geliefert. Diese wird über einen Längswiderstand 2 einem nach Masse angeschlossenen Querzweig zugeführt, der die Reihenschaltung eines ersten Kondensators 3 und eines dazugehörenden Vorwiderstandes 4 enthält. Dieser Zweig kann ggf. auch weitere Parallelzweige mit ähnlichem Aufbau oder auch einen Parallelkondensator ohne Vorwiderstand enthalten.

Die am Verbindungspunkt der Widerstände 2 und 4 auftretende Spannung wird der Ausgangsklemme 5 und von dort einer zu regelnden Stufe, z. B. einem spannungsabhängig gesteuerten Oszillator 6 zugeführt. An die Klemme 5 ist weiter ein Widerstand 7 angeschlossen, der an dem einen Umschaltkontakt 8 eines Umschalters 9 liegt, dessen Zunge 10 über einen zweiten Kondensator 11 von z. B. 4,7 µF und ggf. einen Widerstand 12 mit Masse verbunden ist. Der Widerstand 7 und ggf. der Widerstand 12 liegt als zweiter Widerstand im Stromkreis des Kondensators 11, wenn dieser in der nicht dargestellten Lage der Zunge 10 des Umschalters 9 im Glättungsfilter wirksam ist.

An die Gleichspannungsleitung, an die der Kondensator 3 über den Widerstand 4 angeschlossen ist, ist der hochohmige Eingang eines Verstärkers 13 angeschlossen, der zwischen einer Speiseklemme +U von 12 Volt und Masse angeschaltet ist. Sein niederohmiger Ausgang ist mit der zweiten Klemme 14 des Umschalters 9 verbunden. An dieser Klemme 14 tritt mit geringer Impedanz die gleiche Spannung auf, die an der Reihenschaltung von Kondensator 3 und Widerstand 4 anliegt. Der Verstärkungsfaktor des Verstärkers 13 entspricht also wenigstens annähernd 1. Diese Spannung wird in der dargestellten Lage der Zunge 10 des Umschalters 9 dem Kondensator 11 in jedem Augenblick zugeführt. Wenn dann der Schalter 9 umgeschaltet wird, wird diese Spannung vom Kondensator 11 zur Ausgangsklemme 5 übertragen, wobei sich ersichtlich keine störende Spannungsänderung ergeben kann.

Der Umschalter 9 kann erspart werden und der Kondensator 11 kann mit dem Ausgang des Verstärkers 13 und außerdem auch dem Widerstand 7 dauernd verbunden bleiben, wenn der Verstärker 13 mittels einer einer gestrichelt gezeichneten Klemme 15 zugeführten Schaltspannung zwischen dem Verstärkungsgrad 1 und Null umgeschaltet werden kann. Die Kontakte 8 und 14 stehen dann in dauernder Verbindung mit der Zunge 10. Beim Verstärkungsgrad 1 ergibt sich die erwähnte Übertragung der Spannung vom Kondensator 3 auf den Kondensator 11. Dann besteht zwischen dem Kondensator 11 und der Ausgangsklemme 5 keine Spannungsdifferenz, und entsprechend fließt über den Widerstand 7 kein Strom: Der Kondensator 11 ist also nicht durch Ladung und Entladung speichernd und glättend für die Spannung an der Ausgangsklemme 5 wirksam. Wird jedoch der Verstärker 13 auf die Verstärkung Null umgeschaltet, so wird sein Ausgang hochohmig, und der Kondensator 11 ist über den Widerstand 7 an die Ausgangsklemme 5 angeschlossen und im Glättungsfilter wirksam. Der Widerstand 7 kann einen geringen Wert aufweisen; denn bei wirksamem Verstärker 13 liegt an ihm keine Spannung, so daß er also auch keine Belastung in der Schaltung bewirkt.

Eine Ausführungsform dieser ohne Umschaltung arbeitenden Schaltung nach der Erfindung zeigt Fig. 2, in der gleiche Teile wieder mit gleichen Bezugsziffern wie in Fig. 1 versehen sind.

Der Reihenschaltung des ersten Kondensators 3 und des ersten Widerstandes 4 ist hier ein weiterer Kondensator 20 zur Verbesserung der Glättungseigenschaften parallelgeschaltet. Die am Ausgang des Widerstandes 2 und an der Klemme 5 auftretende Spannung wird der Basis eines ersten npn-Transistors 21 zugeführt, dessen Emitter mit dem Emitter eines zweiten npn-Transistors 22 und mit dem Kollektor eines dritten npn-Transistors 23 verbunden ist. Die Basis des Transistors 23 liegt an einer Klemme 24, der eine Schaltspannung V zugeführt wird; der Emitter des Transistors 23 ist über einen Widerstand 25 an Masse angeschlossen. Die Kollektoren der Transistoren 21 und 22 sind über die Kollektor-Emitter-Strecken zweier pnp-Transistoren 27 bzw. 28 an die Speisequelle +U von 12 Volt angeschlossen. Der Kollektor des Transistors 27 liegt außerdem an der Basis eines pnp-Transistors 29, dessen Emitter an die verbundenen Basen der Transistoren 27 und 28 und dessen Kollektor an Masse angeschlossen ist. Die Transistoren 27, 28 und 29 bilden eine Stromspiegelschaltung, durch die die Kollektorströme der Transistoren 21 und 22 gleich gehalten werden.

Der Kollektor des Transistors 22 ist weiter mit der Basis eines npn-Transistors 30 verbunden, dessen Emitter die Basis eines npn-Transistors 31 steuert, der mit seinem Emitter an der Basis des Transistors 22 liegt. Die Kollektoren der Transistoren 30 und 31 sind an +U angeschlossen. Zwischen der Basis des Transistors 22 und Masse liegt weiter die Kollektor-Emitter-Strecke eines npn-Transistors 32 mit Emitterwiderstand 33. Die Basis des Transistors 32 ist an die Klemme 24 angeschlossen. Der Verbindungspunkt des Emitters des Transistors 31 mit dem Kollektor des Transistors 32 und der Basis des Transistors 22 ist weiter mit dem Verbindungspunkt des Kondensators 11 und des Widerstandes 7 verbunden.

Wenn die dargestellte Transistor-Verstärkerschaltung in Betrieb ist dadurch, daß der Klemme 24 eine Schaltspannung von z. B. +1 Volt zugeführt wird, wirken die Transistoren 23 und 32 als Stromquellen einerseits für den Differenzverstärker 21, 22 und andererseits für den Emitterstromzweig des doppelten Emitterfolgers 30, 31. In dieser Schaltung ist sichergestellt, daß die Spannungen an den Basen der Transistoren 21 und 22 immer exakt gleich sind, wobei der Eingang des Transistors 21 sehr hochohmig unf der Basisanschluß des Transistors 22 durch die Wirkung der Emitterfolger 30, 31 sehr niederohmig ist. Die an der Ausgangsklemme 5 auftretende Spannung wird also stets auf den Kondensator 11 übertragen; am Widerstand 7 tritt keine Spannungsdifferenz auf. Der Kondensator 11 wird von den Transistoren 30, 31, 32 erforderlichenfalls umgeladen, wobei der maximale Enrladestrom durch die Stromquelle 32, 33 bestimmt wird.

Wenn die Schaltspannung V an der Klemme 24 auf Null Volt reduziert wird, ist der Verstärker mit den Transistoren 21 bis 32 stromlos und undwirksam. Dann liegt der Kondensator 11 mit Vorwiderstand 12 über den Widerstand 7 an der Ausgangsklemme 5 und bewirkt somit eine Vergrößerung der Zeitkonstante des Glättungsgliedes.

**Patentansprüche**

1. Schaltungsanordnung zum Übertragen einer Gleichspannung mit einem zwischen einer Eingangsklemme (von 1) und einer Ausgangsklemme (5) gegen Ende liegenden umschaltbaren Glättungsglied, das aus wenigstens einem Längswiderstand (2) und dahinter im Querzweig einem, ggf. mit einem ersten Widerstand (4) in Reihe liegenden ersten Kondensator (3) und einem, ggf. mit einem zweiten Widerstand (7) in Reihe liegenden, zweiten Kondensator (11) besteht, der zur Vergrößerung der Zeitkonstante an die Ausgangsklemme (5) angeschaltet werden kann, dadurch gekennzeichnet, daß mit der Ausgangsklemme (5) der Eingang eines Verstärkers (13) mit hoher Eingangsimpedanz und mit einem Verstärkungsfaktor von wenigstens annähernd 1 verbunden ist, dessen Ausgang mit dem zweiten Kondensator (11) derart verbindbar ist, daß dieser im Glättungsglied wahlweise wirksam oder nicht wirksam ist, und daß bei nicht wirksamem Kondensator (11) die Spannung von der Ausgangsklemme (5) über den Verstärker (13) auf den zweiten Kondensator (11) übertragen wird.

2. Schaltungsanordnung nach Anspruch 1, dadurch gekennzeichnet, daß der Ausgang des Verstärkers (13) an einer Ausgangsklemme (14) eines Umschalters (9) liegt, dessen umschaltbare Zunge (10) mit dem zweiten Kondensator (11) verbunden ist und dessen andere Ausgangsklenme (8) an die Ausgangsklemme (5) des Glättungsgliedes angeschlossen ist.

3. Achaltungsanordnung nach Anspruch 1, dadurch gekennzeichnet, daß der zweite Kondensator (11) über den zweiten Widerstand (7) mit der Ausgangsklemme verbunden ist, und daß parallel zum zweiten Widerstand (7) der Verstärker (13) angeschlossen ist, und daß der verstärker zwischen dem Verstärkungsfaktor wenigstens annähernd Null und wenigstens annähernd 1 umgeschaltet werden kann.

**Claims**

1. A circuit arrangement for transferring a d.c. voltage, comprising a switchable smoothing network which is arranged between an input terminal (of 1) and an output terminal (5), is operative with respect to ground and comprises at least a series resistor (2) followed in a parallel branch by a first capacitor (3) which may be arranged in series with a first resistor (4) and a second capacitor (11) which may be arranged in series with a second resistor (7) and which is connectable to the output terminal (5) for increasing the time constant, characterised in that the input of an amplifier (13) having a high input impedance and a gain factor of at least substantially 1 is connected to the output terminal (5), its output being connectable such to the second capacitor (11) that the latter is optionally operative or not operative in the smoothing network and that when the capacitor (11) is not operative the voltage is transferred from the output terminal (5) to the second capacitor (11) via the amplifier (13).

2. A circuit arrangement as claimed in claim 1, characterised in that the output of the amplifier (13) is connected to an output terminal (14) of a change-over switch (9) whose switchable contact (10) is connected to the second capacitor (11), and whose other output terminal (8) is connected to the output terminal (5) of the smoothing network.

3. A circuit arrangement as claimed in claim 1, characterised in that the second capacitor (11) is connected to the output terminal via the second resistor (7), the amplifier (13) being connected in parallel with the second resistor (7), said amplifier being switchable a gain factor of at least substantially zero and at least substantially 1.

**Revendications**

1. Circuit pour transférer une tension continue, muni d'un élément de nivellement commutable mis à la terre et intercalé entre une borne d'entrée (de 1) et une borne de sortie (5), élément qui est constitué par au moins une résistance en série (2) suivie, dans une branche en parallèle, d'un premier condensateur (3), le cas échéant connecté en série avec une première résistance (4) et d'un second condensateur (11), le cas échéant connecté en série avec une seconde résistance (7), pouvant être raccordé à la borne de sortie (5) pour augmenter la constante de temps, caractérisé en ce qu'à la borne de sortie (5) est reliée l'entrée d'un amplificateur (13) ayant une impédance d' entrée élevée et un gain au moins sensiblement égal à 1 et dont la sortie peut être reliée au second condensateur (11) de façon que celui-ci soit actif ou inactif dans l'élément de nivellement, et en ce que, si le condensateur (11) est inactif, la tension est transférée à partir de la borne de sortie (5) vers le second condensateur à travers l'amplificateur (13).

2. Circuit selon la revendication 1, caractérisé en ce que la sortie de l'amplificateur (13) est reliée à une borne de sortie (14) d'un commutateur (9) dont le contact-mère (10) est relié au second condensateur (11) et dont l'autre borne de sortie (8) est raccordée à la borne de sortie (5) de l'élément de nivellement.

3. Circuit selon la revendication 1, caractérisé en ce que le second condensateur (11) est relié à travers la seconde résistance (7) à la borne de sortie, en ce que l'amplificateur (13) est connecté en parallèle avec la seconde résistance (7) et en ce que l'amplificateur est commutable entre le gain au moins sensiblement nul et un gain au moins sensiblement égal à 1.

1
2
4
3
+U
13
14
8
9
10
11
12
15
5
6
7
FIG.1
+U
27
28
29
30
31
21
22
24
V
23
32
25
33
1
2
20
4
3
FIG.2
5
6
7
11
12